Europäisches Patentamt

European Patent Office

Office européen des brevets

(19)

(11) EP 1 324 400 A1

(12) **EUROPEAN PATENT APPLICATION**
published in accordance with Art. 158(3) EPC

(43) Date of publication:
02.07.2003 Bulletin 2003/27

(51) Int Cl.$^7$: **H01L 35/08**, H01L 35/14, H01L 35/32

(21) Application number: 01965623.0

(22) Date of filing: 13.09.2001

(86) International application number:
PCT/JP01/07957

(87) International publication number:
WO 02/023643 (21.03.2002 Gazette 2002/12)

(84) Designated Contracting States:
AT BE CH CY DE DK ES FI FR GB GR IE IT LI LU
MC NL PT SE TR

(30) Priority: 13.09.2000 JP 2000278775

(71) Applicant: SUMITOMO SPECIAL METALS
COMPANY LIMITED
Osaka-shi, Osaka 541-0041 (JP)

(72) Inventors:
• SADATOMI, Nobuhiro
Ibaraki-shi, Osaka 567-0806 (JP)
• SAIGO, Tsunekazu
Matsubara-shi, Osaka 580-0033 (JP)

(74) Representative: Butler, Lance
Barker Brettell
10-12 Priests Bridge
London SW15 5JE (GB)

(54) **THERMOELECTRIC CONVERSION ELEMENT**

(57)    A high-performance thermoelectric conversion ele-ment using an Si-group thermoelectric conversion material, and an thermoelectric conversion element capable of providing a high-out-put power by improving a power -generating efficiency, wherein the thermal expansion coefficient of an electrode material is set to up to 1 0 ppm/K in order to provide a good electrode joining between a p-type thermoelectric conversion material and a n-type thermo-electric. conversion material consisting of an Si-group thermoelec-tric conversion material to thereby ease thermal stress and prevent cracking and breaking at a joining portion, and, in joining, a brazing filler material selected according to a working temperature range is interposed to thereby provide good joining characteristics, reduce an output loss, and improve a heat resistance and a heat -cycle resistance.

Fig. 3A

EP 1 324 400 A1

**Description**

TECHNICAL FIELD

This invention relates to an improvement to a thermoelectric Conversion element made using a silicon-based thermoelectric Conversion material, which does not pollute the environment, is lightweight, and Can be produced inexpensively, and more particularly relates to a thermoelectric Conversion element in which a p type thermoelectric Conversion material and an n type thermoelectric Conversion material are joined in series with an electrode material whose Coefficient of thermal expansion is Close to that of the thermoelectric Conversion materials via a special solder, thereby enhancing power generation efficiency and obtaining a higher power output.

BACKGROUND ART

Issues related to energy and the environment, including Curtailing Carbon dioxide [emissions], have become a major Concern in recent years. The practical application of thermoelectric Conversion elements, which are Capable of Converting heat directly into electricity, is one especially promising technology in terms of the efficient utilization of waste heat.

Nevertheless, among the problems faced today are the low performance index of thermoelectric Conversion materials, the environmental impact of the elements used in these materials, and the high Cost thereof. Technology for producing elements from thermoelectric Conversion materials, and technologies for utilizing these elements, are still somewhat lacking, and the thermoelectric Conversion materials and elements that have found practical application are Currently still under development.

For a thermoelectric Conversion material to be utilized as a thermoelectric Conversion element, the element must, for example, be structured such that a p type thermoelectric Conversion material, which generates positive electromotive force, and an n type thermoelectric Conversion material, which generates negative electromotive force, are Connected in series, and the output powder is taken off from these materials with an electrode. To obtain a high output, a high-performance material must be used and output loss in the element must be kept to an absolute minimum.

Therefore, a thermoelectric Conversion element must itself have a large electromotive force and a low internal resistance. From a material standpoint, a Bi-Te-based thermoelectric Conversion material is one of the most efficient of the thermoelectric Conversion materials available today, but the melting point of the material is only 240°C, and this material is also prone to oxidation at high temperatures, so while it is effective when it Comes to the Cooling of a Peltier element or the like, a narrow temperature range is a problem in thermal power generation.

Also, Pb-Te-based thermoelectric Conversion materials are prone to oxidation, and require the use of elements that are bad for the environment. Fe-Si-based thermoelectric Conversion materials have a high Seebeck Coefficient, but because of the high resistivity of these materials, they are plagued by problems such as low output and have yet to reach a practical level.

Si-Ge-based thermoelectric Conversion materials are known to be materials suited to high temperatures, but they are expensive because they Contain as much as 20 to 30 atom% Costly germanium, and another problem with silicon and germanium is the wide solid phase line and liquid phase line in a Complete solid solution, and producing a uniform Composition by dissolution or ZL (Zone Leveling) process is so difficult that industrial application is unfeasible.

Meanwhile, a method for manufacturing a thermoelectric Conversion element in which an Si-Ge-based thermoelectric Conversion material, which was known in the past as discussed above, and an electrode material are subjected to plasma sintering in a Contact state, thereby integrating the thermoelectric Conversion material and the electrode, has been proposed in Japanese Laid-Open Patent Application H10-74986.

Japanese Laid-Open Patent Application H10-144970 proposes a thermoelectric Conversion module in which the heat transfer Component of a thermoelectric Conversion module made from an Si-Ge-based thermoelectric Conversion material with a high germanium Content is Composed of a metal layer or a metal sheet Coated with a Ceramic layer, providing electrical insulation between the heat transfer Component and the metal segment of the thermoelectric Conversion element and good thermal Conduction.

Japanese Laid-Open Patent Application H10-209510 proposes a manufacturing method in which an electrode joint made of an Si-Ge-based thermoelectric Conversion material with a high germanium Content is Coated with a paste Containing a specific metal powder, and then heat treated.

The inventors have previously focused on the fact that silicon, which is widely used in semiconductor devices, has an extremely high Seebeck Coefficient, and in particular have evaluated the thermoelectric Characteristics of silicon-based materials, and as a result have learned that a thermoelectric Conversion material with a high performance index Can be obtained by adding a small amount of other element (0. 001 to 20 atom%) to silicon (W099/22410).

The thermal Conductivity Can be lowered in the above-mentioned silicon-based materials by adding various dopants, and Compared to Conventionally known Fe-Si-based materials and Si-Ge-based materials with a high germanium Content, the Seebeck Coefficient at a specific Carrier Concentration is the same or higher, and these silicon-based materials exhibit a high performance index as thermoelectric Conversion materials, and Can therefore meet the need for higher performance.

Silicon-based materials have a high melting point and Can be used at high temperatures, and are also Characterized by a high Seebeck Coefficient, low internal resistance, and high electromotive force. Furthermore, their environmental impact is minimal, they are light in weight, and Can be produced inexpensively. In using a silicon-based thermoelectric Conversion material having these Characteristics and a high thermoelectric Conversion efficiency to produce a high-performance thermoelectric Conversion element, it is necessary to employ a structure that minimizes the output loss for the element as a whole.

DISCLOSURE OF THE INVENTION

It is an object of the present invention to provide a high-performance thermoelectric Conversion element made from a silicon-based thermoelectric Conversion material. and is a further object to provide a thermoelectric Conversion element Constituted such that power generation efficiency is enhanced and a high power output Can be obtained.

As a result of various investigations into a structure that would improve an electrode joint between an n type thermoelectric Conversion material and a p type thermoelectric Conversion material Composed of a silicon-based thermoelectric Conversion material in an effort to increase power generation efficiency and minimize output loss for the element as a whole, the inventors found that if there is too much difference between the Coefficient of thermal expansion of the above-mentioned materials (4 ppm/K) and the Coefficient of thermal expansion of the electrode material, thermal stress will Cause Cracking and splitting at the joint, resulting in an output loss, and if the temperature differential between the high and low temperature sides of the element is too great, heat resistance and heat Cycle resistance will be poor, and furthermore breaks in Conduction and damage to the element will occur. The inventors learned that the thermal stress Can be lessened, and the above problems solved, by keeping the Coefficient of thermal expansion of the electrode material to 10 ppm/K or less.

The inventors perfected the present invention upon discovering that if a solder is selected according to the temperature range used in the joining of a p type thermoelectric Conversion material and an n type thermoelectric Conversion material using an electrode Composed of a material whose Coefficient of thermal expansion is no more than 10 ppm/K, good joint Characteristics will be obtained, output loss will be reduced, and heat resistance and heat Cycle resistance will be enhanced.

Specifically, the present invention is a thermoelectric Conversion element Characterized in that one or more pairs of p type thermoelectric Conversion material and n type thermoelectric Conversion material Composed of a silicon-based thermoelectric Conversion material are joined with an electrode Composed of a material whose Coefficient of thermal expansion is 10 ppm/K or less, such as molybdenum, tungsten, niobium, zirconium, tantalum, titanium, vanadium, Carbon, an Fe-Ni-based alloy, an Fe-Cr-Ni-based alloy, an Fe-Ni-Co-based alloy, or an Al-Si-based alloy.

The present invention is also a thermoelectric Conversion element Characterized in that, in the above Constitution, a solder such as silver-based solder, Copper-based solder, nickel-based solder, gold-based solder, titanium-based solder, aluminum-based solder, palladium-based solder, tin-based solder, or phosphor bronze is interposed between the thermoelectric Conversion material and the electrode for joining same.

The inventors also turned their attention to integrating n- and p-type materials as a way to extract electrical power with a thermoelectric Conversion element without sacrificing the thermoelectric Characteristics of silicon-based thermoelectric Conversion materials and so forth. Integration methods they tried included powder metallurgical processes such as sintering a powder after Cold Compression molding, or hot Compression molding such as hot pressing, discharge plasma sintering, or hot hydrostatic pressing, as well as patterning a resist of a powder material on a silicon substrate.

The inventors learned that if, in this integration, an insulating material such as a powder based on silicon, a Ceramic, or the like were interposed somewhere other than at the pn junction, the integration would be far easier and the pn junction loss would be greatly reduced, and the thermoelectric Conversion efficiency would be increased, and that if these materials were disposed in alternating fashion as p/n/p/n/p to produce an integrated sinter, the loss resulting from the electrode junction would be negligible, and it would be possible to produce an element that underwent no junction separation or Cracking as a result of thermal stress.

The inventors also attempted to produce an element by interposing different types of metal at the pn junction located on the high- and low-temperature sides when a temperature gradient was imparted to a thermoelectric Conversion element, with the junction methods Comprising inserting a metal powder at the p/n powder boundary during powder sintering, and interposing a metal sheet at the p/n boundary. The voltage and Current of elements joined and integrated by the above-mentioned powder metallurgical processes were measured, which revealed that electromotive power and electric energy increase when the metal material is optimally selected, that is, when one of the above-mentioned materials is selected.

The present invention was perfected upon discovering that it is possible to join a bulk of a silicon-based sintered material or welded material with an electrode material by resistance heating, resistance sintering, hot pressing or another press bonding method, firing a paste material, welding, or another such method, and that electromotive force and electric energy are increased, without any electrode junction loss, if the above-mentioned optimal electrode material is selected.

The inventors also propose, in the above-mentioned Constitution:

a Constitution in which the silicon-based thermoelectric Conversion material Contains no more than 10 atom% (including 0) of at least one of germanium, Carbon, and tin;

a Constitution in which the silicon-based thermoelectric Conversion material has a Crystal structure including Crystal grains of which silicon accounts for 80 atom%, and a grain boundary phase in which one or more types of dopant have precipitated at the grain boundary of these Crystals;

a Constitution in which the p type thermoelectric Conversion material Contains a Group III element and a Group II element, either singly or Compounded, in an amount of 0. 001 to 10 atom%, and has a Carrier Concentration of $10^{18}$ to $10^{21}$ M/m$^3$;

a Constitution in which the n type thermoelectric Conversion material Contains Group V and Group VI elements, either singly or Compounded, in an amount of 0. 001 to 10 atom%, and has a Carrier Concentration of $10^{18}$ to $10^{21}$ M/m$^3$; and

a Constitution in which the p- and n-type thermoelectric Conversion materials Contain a Group III-Group V Compound and a Group II-Group VI Compound, either singly or Compounded, in an amount of 1 to 10 atom%, and has a Carrier Concentration of $10^{18}$ to $10^{21}$ M/m$^3$.

BRIEF DESCRIPTION OF THE DRAWINGS

Fig. 1A is a diagram illustrating an example of the Constitution of a thermoelectric Conversion element, and Fig. 1B is an electric Circuit schematic;

Fig. 2 is a graph of the relationship of the voltage E, Current I, and the power P to the external load;

Fig. 3A is a diagram illustrating an example of the Constitution of a thermoelectric Conversion element, and Fig. 3B is an electric Circuit schematic;

Fig. 4 is a graph of the relationship of the voltage E, Current I, and the power P to the external load;

Fig. 5 Consists of facsimiles of EPMA photographs of the Crystal structure of the thermoelectric Conversion material pertaining to the present invention (Si$_{0.97}$Ge$_{0.03}$), with Fig. 5A showing the segregation of germanium dopant, and Fig. 5B the segregation of phosphorus dopant;

Fig. 6 Consists of facsimiles of EPMA photographs of the Crystal structure of the thermoelectric Conversion material pertaining to the present invention (Si$_{0.95}$Ge$_{0.05}$), with Fig. 6A showing the segregation of germanium dopant, and Fig. 6B the segregation of phosphorus dopant;

Fig. 7 Consists of facsimiles of EPMA photographs of the Crystal structure of the thermoelectric Conversion material pertaining to the present invention (Si$_{0.9}$Ge$_{0.1}$), with Fig. 7A showing the segregation of germanium dopant, and Fig. 7B the segregation of phosphorus dopant;

Fig. 8 Consists of facsimiles of EPMA photographs of the Crystal structure of a Comparative thermoelectric Conversion material (Si$_{0.85}$Ge$_{0.15}$), with Fig. 8A showing the segregation of germanium dopant, and Fig. 8B the segregation of phosphorus dopant;

Fig. 9 is a schematic diagram of the Crystal structure of the thermoelectric Conversion material pertaining to the present invention;

Figs. 10A and 10B are material layout diagrams illustrating the method for manufacturing the thermoelectric Conversion element pertaining to the present invention, when a pn junction is formed directly by powder metallurgy,

Fig. 11A is a material layout diagram illustrating the method for manufacturing the thermoelectric Conversion element pertaining to the present invention, when a pn junction is formed by powder metallurgy with an electrode powder interposed, Fig. 11B shows the molded article, and Fig. 11C shows a different layout for the electrode powder and the insulating material powder in A; and

Fig. 12A is a material layout diagram illustrating the method for manufacturing the thermoelectric Conversion element pertaining to the present invention, when a pn junction is formed by powder metallurgy with a thin electrode plate interposed, Fig. 12B shows the Case when a pn junction is formed between bulk materials by press bonding, and Fig. 12C shows the Case when a paste is used for the bulk material.

BEST MODE FOR CARRYING OUT THE INVENTION

The silicon-based thermoelectric Conversion material that is the object of the present invention represents an improvement to the silicon-based material discussed above and already known to the inventors (WO99/22410), and is Characterized by having silicon as its main Component and Containing a dopant that generates Carriers in silicon (a Group III or Group II element for p-type, and a Group V or Group VI element for n-type), in an amount of 0.001 to 10 atom%, either singly or Compounded, and having a Carrier Concentration of $10^{18}$ to $10^{21}$ M/m$^3$, or Containing a dopant that generates Carriers in silicon, in an amount of 0.001 to 10 atom%, either singly or Compounded, and having a Carrier Concentration of $10^{18}$ to $10^{21}$ M/m$^3$, and a dopant (germanium, Carbon, tin) that does not generate Carriers, in an amount of 0. 1 to 10 atom%, either singly or Compounded.

This silicon-based thermoelectric Conversion material represents an improvement to the silicon-based material discussed above and already known to the inventors (WO99/22410), and is Characterized by a structure in which a Crystal phase that is substantially silicon but also includes dopants, which are added regardless of whether Carriers are generated, and the above-mentioned dopants are segregated simultaneously at the grain boundary of this Crystal phase. For the sake of Convenience, the Crystal phase of which silicon accounts for at least 80 atom% will be referred to herein as the silicon-rich phase, and the grain boundary phase of which one or more types of dopant account for at least half will be referred to as the dopant-rich phase.

The dopant-rich phase refers to that part of the Crystal phase in which one or more types of dopant are deposited at the grain boundary of the silicon-rich phase, and includes everything from what is deposited as if adhering to the silicon-rich phase, to what is deposited as if surrounding [the silicon-rich phase] in layer form, depending on the added amount. A tiny amount of silicon may also sometimes be deposited at the grain boundary.

The structure in which the above-mentioned dopant-rich phase is formed at the grain boundary of the silicon-rich phase will now be described. First, $Si_{1-x}Ge_x$ melts (at%) were produced by arc melting, with varied amounts of germanium (4N) added to high-purity silicon (10N), sample substrates were produced by rapid Cooling at a rate of 50 to 200 K/sec after this melting, and the Crystal structure was observed by EPMA.

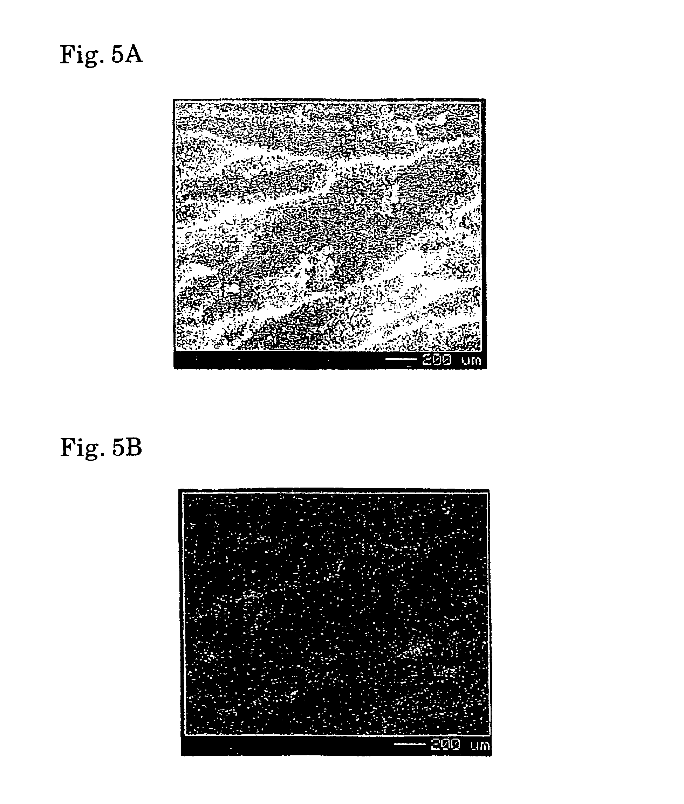

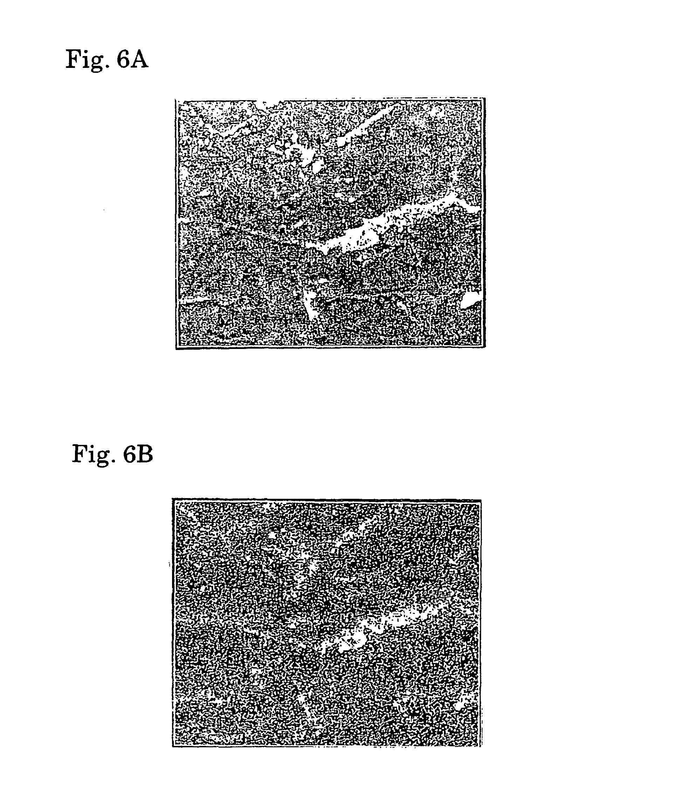

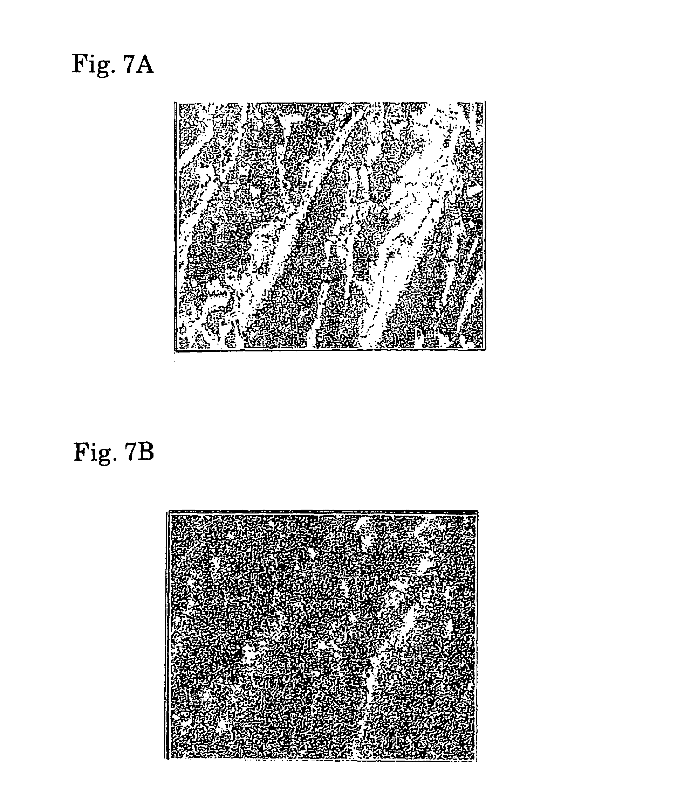

More specifically, as shown in Fig. 5A (when x = 0.03), Fig. 6A (when x = 0.05), and Fig. 7A (when x = 0.1), the black areas in the photograph are the silicon-rich phase, which is almost entirely silicon, but also includes a tiny amount of dopant, and the white areas are the dopant (germanium)-rich phase. It Can be seen that this is a structure in which the germanium-rich phase is dispersed or formed in a large amount at the grain boundary of the silicon-rich phase.

A tiny amount of phosphorus was added to the above-mentioned $Si_{1-x}Ge_x$ melts, and when just this phosphorus was observed, as shown in the EPMA photographs in Figs. 5B, 6B, and 7B, the white areas are places where the added phosphorus was present, and it Can be seen that this is a structure in which phosphorus is segregated at the same locations of the grain boundary of the silicon-rich phase as where the above-mentioned germanium-rich phase was formed in Figs. 5A to 7A.

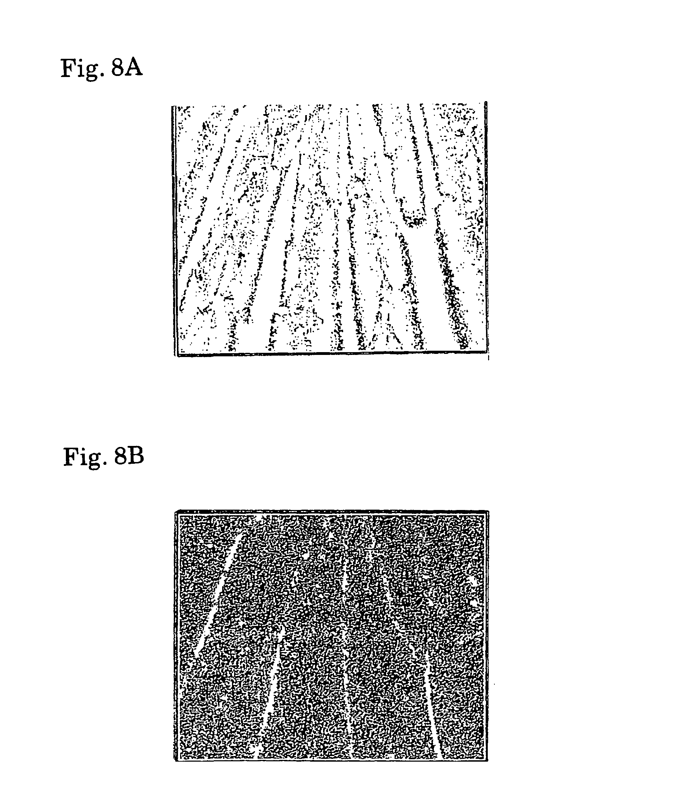

Meanwhile, as shown in Fig. 8A, which is an EPMA photograph of when just germanium was observed, with the above-mentioned Sil-xGex melt and when x = 0. 15, and in Fig. 8B, which is the results of observing just phosphorus, the overall structure becomes an alloy phase Comprising a solid solution of silicon and germanium, and it is Clear that this is Completely different from the structure of the thermoelectric Conversion material pertaining to the present invention.

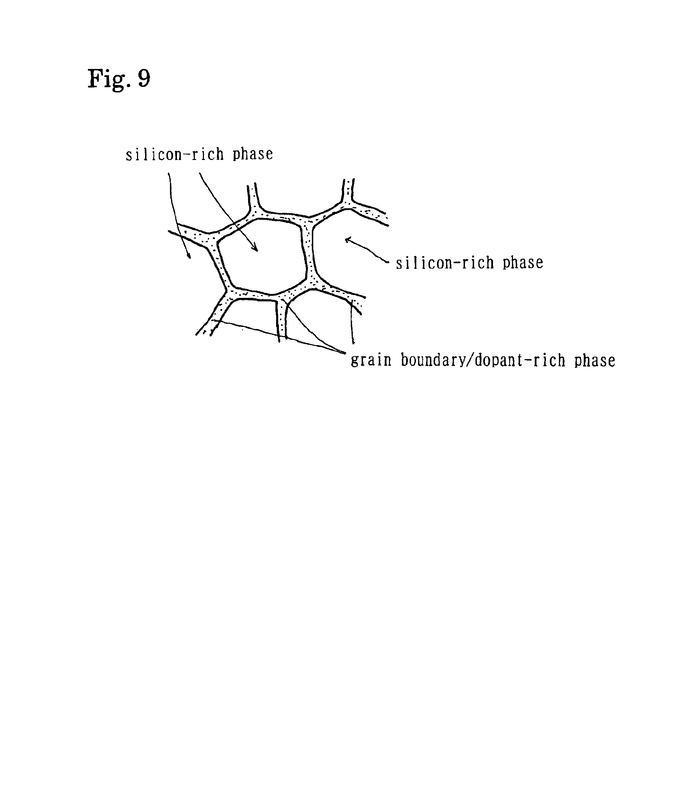

In other words, as shown in the schematic of Fig. 9, the structure of the silicon-based thermoelectric Conversion material pertaining to the present invention Comprises a silicon-rich phase, which is made up of just silicon, or is almost entirely silicon but also includes a tiny amount of dopant, and a dopant-rich phase in which a dopant such as germanium is segregated at the grain boundary of this silicon-rich phase.

With a silicon-based thermoelectric Conversion material, the dopant-rich phase in which a dopant accumulates at the grain boundary increases the transmission of Carriers, while the silicon-rich phase, which is the main phase, provides a high Seebeck Coefficient, and a thermoelectric Conversion material having a high performance index and having a structure in which a silicon-rich phase and a dopant-rich phase are dispersed at the required locations within the material Can be obtained by Controlling the Cooling rate during melting and solidification.

The size of the silicon-rich phase will vary with the Cooling rate, but is about 1 to 500 µm. Thus, the silicon-based thermoelectric Conversion material that is the object of the present invention is Completely different in terms of Composition, structure, Characteristics, and so forth from Si-Ge-based thermoelectric Conversion materials Containing at least 20 atom% germanium and known in the past as high-temperature thermoelectric semiconductor materials.

It is preferable for at one element of germanium, Carbon, and tin to be Contained as a dopant that does not generate Carriers. A Group III or Group V element Can also be added to the germanium, Carbon, or tin, and a Group III-Group V Compound or Group II-Group VI Compound Can also be added in order to lower the thermal Conductivity.

If at least one of germanium, Carbon, and tin is not Contained in an amount of at least 0. 1 atom%, the thermal Conductivity will be so high that a high performance index will not be obtained, but if the amount is over 10 atom%, there will be a Certain drop in thermal Conductivity, and the dopant will also diffuse and become a solid solution in the silicon-rich phase, so the high Seebeck Coefficient of the silicon will decrease, resulting in an inferior performance index. Therefore, it is preferable for the Content of at least one element of germanium, Carbon, and tin to be 0.1 to 10 atom%, with a range of 3 to 10 atom% being even better.

Furthermore, when a Group III or Group V element is added, and when a Group III-Group V Compound or Group II-Group VI Compound is added, it is preferable for the Combined amount of the Group III element or Group V element and at least one of germanium, Carbon, and tin to be 5 to 10 atom%, and for the Group III-Group V Compound or Group II-Group VI Compound to be added in an amount of 1 to 10 atom%.

As for the dopants that generate Carriers, it is preferable for the resulting thermoelectric Conversion material, the dopant serving as a material that exhibits p type Conductivity (called the dopant Ap), and the dopant serving as a material that exhibits n-type Conductivity (called the dopant An) each to be Contained in an amount of 0.001 to 10 atom%.

It is preferable for the dopant that generates Carriers and serves as a material exhibiting p type Conductivity to Comprise a Group III element (boron, aluminum, gallium, indium, thallium) and/or a Group II element (beryllium, magnesium, Calcium, strontium, barium) to be added, singly or Compounded, in an amount of 0.001 to 10 atom%. Of these, particularly favorable elements are boron, aluminum, and gallium. Along with the above-mentioned dopants, one or more members selected from the transition metal element group $M_1$ ($M_1$: yttrium, molybdenum, zirconium) Can also be included.

It is preferable for the dopant that generates Carriers and serves as a material exhibiting n-type Conductivity to Comprise a Group V element (nitrogen, phosphorus, arsenic, antimony, bismuth) and/or a Group VI element (oxygen, sulfur, selenium, tellurium, polonium) to be added, singly or Compounded, in an amount of 0. 001 to 10 atom%. Of these, particularly favorable elements are phosphorus, arsenic, antimony, and bismuth.

Along with the above-mentioned dopants, one or more members selected from the transition metal element group $M_2$ ($M_2$: titanium, vanadium, Chromium, manganese, iron, Cobalt, nickel, Copper, niobium, ruthenium, rhodium, palladium, silver, hafnium, tantalum, tungsten, rhenium, osmium, iridium, platinum, and gold, where the iron Content is no more than 10 atom%) and the rare earth element group RE (RE: lanthanum, Cerium, praseodymium, neodymium, promethium, samarium, europium, gadolinium, terbium, dysprosium, holmium, erbium, ytterbium, lutetium) Can also be included.

The above-mentioned silicon-based thermoelectric Conversion material is obtained by Cooling the melt, arc welding and high-frequency welding are the preferred melting methods because of their suitability to mass production. The Cooling rate Can be suitably selected as dictated by the type, Combination, added amount, etc., of the above-mentioned dopants, the Cooling method employed, and the form in which the product is obtained, such as an ingot, thin sheet, substrate, or ribbon.

The Cooling Can involve directly Cooling an ingot, or Cooling while the product is pulled up, such as a method in which a standard CZ or FZ process for obtaining monocrystalline silicon is utilized to Cool the material while it is pulled up under Conditions that will yield polycrystalline silicon. Since a CZ or FZ process allows number substrates of the required thickness to be manufactured from a pulled ingot bar, it is suitable as a method for manufacturing a silicon-based thermoelectric Conversion material that will be used for a thermoelectric Conversion element.

Manufacture by ZL process is also possible. Various other methods Can also be employed, such as a method in which a thinner sheet is produced by Casting and Cooling the melt in a shallow plate, or using a known melt quenching method or other such roll Cooling method to Control the Cooling rate so as to obtain a thin sheet of the required thickness.

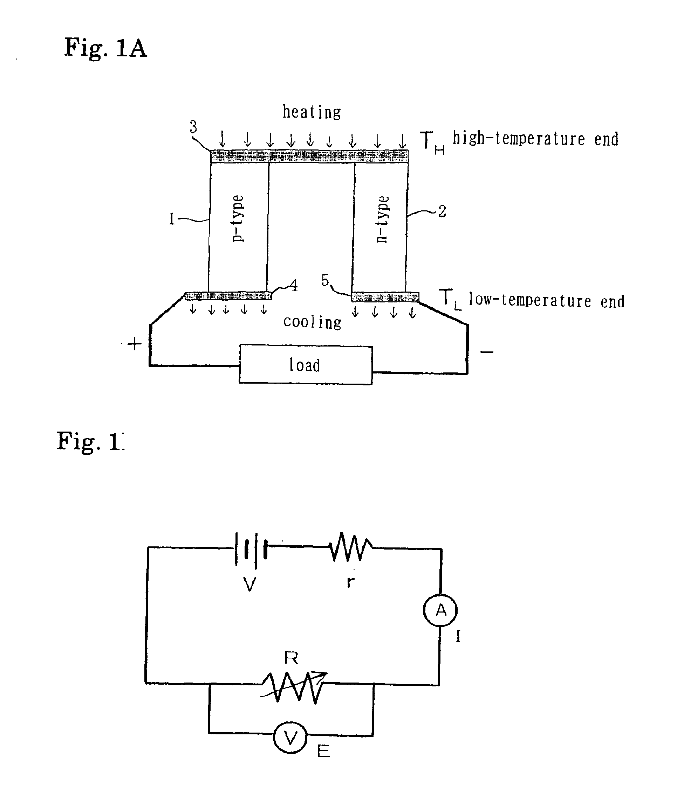

A thermoelectric Conversion element is structured such that a temperature differential on the high and low temperature sides is provided to a thermoelectric Conversion material, and the electromotive force and Current thus generated are taken off as electrical power. For example, as shown in Fig. 1A, when the upper side (in the drawing) of a p type thermoelectric Conversion material 1 and an n type thermoelectric Conversion material 2 that are disposed side by side is the high temperature side, and the lower side is the low temperature side, then the p type thermoelectric Conversion material 1, which generates a positive electromotive force, and the n type thermoelectric Conversion material 2, which generates a negative electromotive force, are serially Connected via an electrode 3 between the high-temperature terminals TH, and the output power from these materials is taken off from electrodes 4 and 5 provided to the low-temperature terminals TL.

An electrical Circuit diagram is shown in Fig. 1B. If we let V be the electromotive force of the thermoelectric Conversion material, r be the internal resistance of the entire element, R be the external load resistance, I be the Current flowing to the Circuit, and E be the voltage applied to the external load, then $I = V/(R + r)$, and $E = RI = RV/(R + r)$. The electric energy P thus obtained is $P = EI = R\{V/(R + r)^2)\}$. The electrical energy P is at its maximum value when $R = r$, and $Pmax = V^2 \cdot 4r$.

Therefore, to obtain a large output, the electromotive force V of the thermoelectric semiconductor material must be large and the internal resistance r must be small. Increasing the electromotive force V requires that the Seebeck Coefficient S of the material be large, and that the temperature differential ($\Delta T = T_H - T_L$) imparted to the material be large as well.

Also, lowering the internal resistance r of the material requires the resistivity of the material to be lowered, and the Cross sectional area s of the material to be increased and the length L shortened, so as to reduce the Contact resistance between the material and the electrode. In addition to the structure shown in the drawings, the thermoelectric Conversion element Can also have any other known structure.

The silicon-based thermoelectric Conversion material of the present invention discussed above has an average Coefficient of thermal expansion of approximately 4 ppm/K at 30 to 800°C. It is preferable for the average Coefficient of thermal expansion of the electrode material joined to the above-mentioned material to be no more than 10 ppm/K in the same temperature range.

Molybdenum, tungsten, niobium, zirconium, tantalum, titanium, vanadium, Carbon, an Fe-Ni-based alloy, an Fe-Cr-Ni-based alloy, an Fe-Ni-Co-based alloy, an Al-Si-based alloy, or the like is favorable as the electrode material. Specific examples include 32-42Ni-Fe, 29Ni-8Co-Fe, and 50Si-Al.

It is also preferable to use a solder in to join the electrode material to the silicon-based thermoelectric Conversion material. Favorable examples of solder materials include silver-based solder, Copper-based solder, nickel-based solder, gold-based solder, titanium-based solder, aluminum-based solder, palladium-based solder, tin-based solder, and phosphor bronze. Specific examples include Ag-Cu, Ag-Cu-Zn, Ag-Mn, Ag-Au, Ag-Si, Cu-P, Cu-Zn, Cu-Sn, Cu-Si, Ni-Si, Ni-P, Ni-Cr, Au-Si, Au-Cu, Au-Al, Ti-Ni, Ti-Ni-Cu, Pd-Ni, Pd-Ag, Sn-Ag-Cu, Sn-Cu, and Sn-Sb.

The solder should be selected according to the temperature range over which the thermoelectric Conversion element will be used. For instance, if it is to be used at a high temperature of 800°C or more, a Copper-based solder, nickel-based solder, titanium-based solder, or palladium-based solder is preferred, and if it is to used at a medium temperature of 400 to 600°C or at a low temperature of 200°C or less, a silver-based solder, gold-based solder, or a solder such as Au-Si or Al-Si Can be used.

The material for the solder should also be selected so that no alloys or intermetal Compounds are produced with the silicon-based thermoelectric Conversion material at the soldering temperature. If alloys or intermetal Compounds are produced, the metal layer or intermetal layer should be kept to no more than 0. 1 mm from the surface, to the extent that it has no effect on the silicon-based thermoelectric Conversion material.

The solder thickness during soldering is 0. 01 to 0. 2 mm, and should be as thin as possible, with about 0. 05 mm being suitable. As to the soldering Conditions, with an Ag-Cu solder, for example, the soldering is performed in a reductive atmosphere at 800 to 860°C, and if the solder is based on titanium, the soldering should be performed in an inert gas or in a vacuum at 900 to 960°C.

The Coefficient of thermal expansion as used in the present invention is defined as follows.

Coefficient of thermal expansion: The average Coefficient of thermal expansion between room temperature (about 25°C) and the soldering temperature (800 to 900°C),

$$\alpha = \Delta 1/1 \cdot \Delta T$$

H: soldering temperature
L: room temperature

$$\Delta T = T_H - T_L$$

$$\Delta 1 = 1_H - 1_L$$

1: extension
H: length at soldering temperature
L: length at room temperature

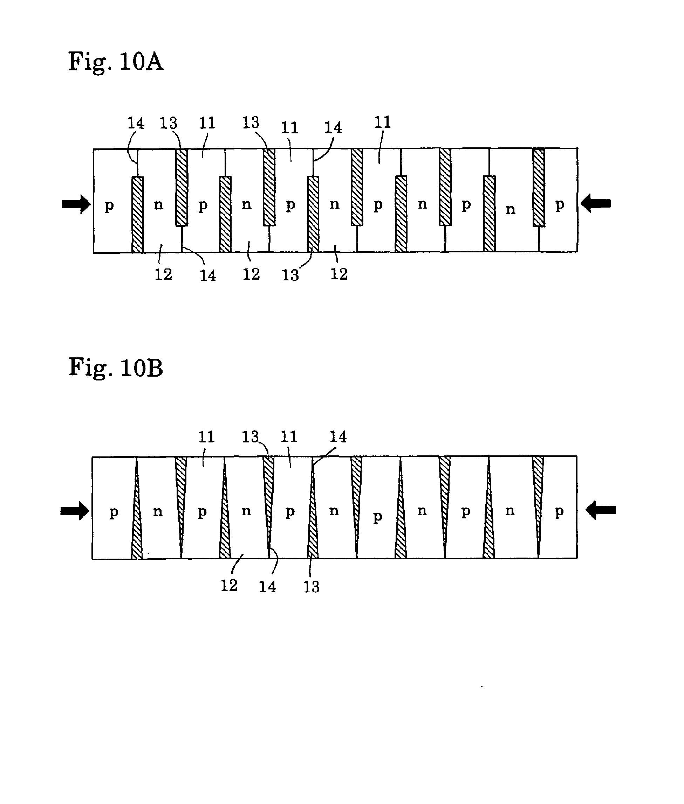

Next, an example of the method for manufacturing the thermoelectric Conversion element pertaining to the present invention will be discussed in detail through reference to the drawings. Fig. 10A illustrates a Case of direct pn junction by powder metallurgy. Powders that Can be sintered Can be used for each of the p-type thermoelectric Conversion material powder 11, the n-type thermoelectric Conversion material powder 12, and the insulating material powder 13.

For example, the p-type thermoelectric Conversion material powder 11, the n-type thermoelectric Conversion material powder 12, and the insulating material powder 13 are alternately inserted into a box-shaped mold using tuning-fork-shaped separators arranged with their open ends alternately reversed, then the separators are taken out, a lid is provided over the top, and the powders are Compressed toward the Center of the mold in the direction of the arrows, thereby producing a molding.

This molding is structured such that the p-type thermoelectric Conversion material powder 11 and the n-type thermoelectric Conversion material powder 12 are arranged alternately, separated by the insulating material powder 13 except at the places 14 where a pn junction is to be formed. The molding is then sintered, which produces an integrated thermoelectric Conversion element in which the insulating material is integrated between the thermoelectric Conversion materials and which has a plurality of pn junctions, joined directly by sintering, in the direction in which the thermoelectric Conversion materials are linked.

In Fig. 10A, it should go without saying that a linked type of thermoelectric Conversion element Consisting of a plurality of direct pn junctions produced by sintering Can be manufactured also by Changing the insulating material powder 13 portion to a preformed insulator sheet, plate, or the like. A single pair type of thermoelectric Conversion element Consisting of just one direct pn junction Can be similarly manufactured.

In the manufacturing example shown in Fig. 10B, the p-type thermoelectric Conversion material powder 11, the n-type thermoelectric Conversion material powder 12, and the insulating material powder 13 are alternately inserted into a box-shaped mold using triangular separators arranged with their open ends alternately reversed, and such that no insulating material powder gets into the very tip portions of the triangular separators, then the separators are taken out, and the powders are Compressed toward the Center of the mold in the direction of the arrows, thereby producing a molding.

This molding is structured such that the p-type thermoelectric Conversion material powder 11 and the n-type thermoelectric Conversion material powder 12 are arranged alternately, separated by the insulating material powder 13 except at the places 14 where a pn junction is to be formed. The molding is then sintered, which produces an integrated thermoelectric Conversion element in which the insulating material is integrated between the thermoelectric Conversion materials and which has a plurality of pn junctions, joined directly by sintering, in the direction in which the thermoelectric Conversion materials are linked.

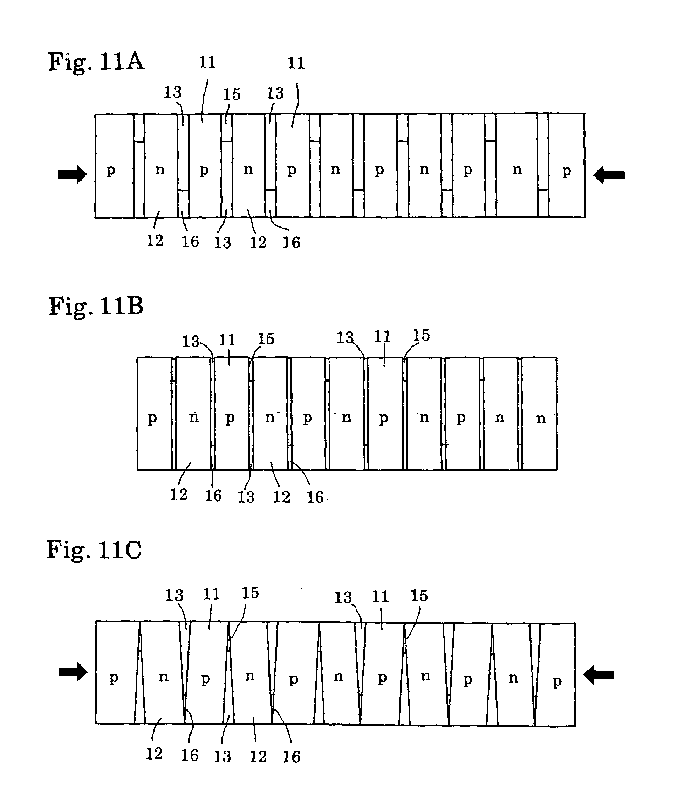

In the manufacturing example shown in Fig. 11A, the insulating material powder 13 and electrode material powders 15 and 16 are packed in between the p- type thermoelectric Conversion material powder 11 and the n-type thermoelectric Conversion material powder 12 into a box-shaped mold as shown in the drawing, with the insertion locations of insulating material powder 13 alternating with those of the electrode material powders 15 and 16, then the powders are Compressed toward the Center of the mold in the direction of the arrows, thereby producing a molding as shown in Fig. 11B.

If a temperature gradient is imparted such that the lower part (in the drawing) of the Completed thermoelectric Conversion element is on the high temperature side near a heat source, and the upper part is on the low temperature side, then different metal or alloy powders are used for the electrode material powders on the high temperature side 16 and the low temperature side 15.

Sintering this molding integrates the insulating material between the thermoelectric Conversion materials, and yields an integrated thermoelectric Conversion element having a plurality of pn junctions, joined by sintering via an electrode material, in the direction in which the thermoelectric Conversion materials are linked.

In addition to packing the insulating material powder 3 and the electrode material powders 15 and 16 into a rectangular shape as shown in Fig. 11A, it is also possible to pack them in a triangular shape between the p-type thermoelectric Conversion material powder 11 and the n-type thermoelectric Conversion material powder 12 as shown in Fig. 11C, and any Configuration desired Can be employed as dictated by the amount of insulating material, the insulation dimensions, and so forth.

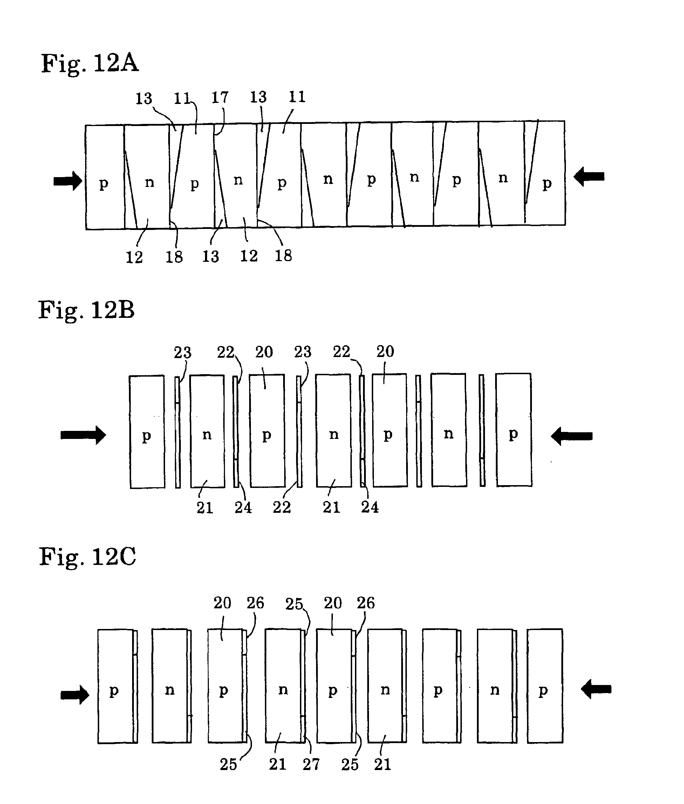

The manufacturing example shown in Fig. 12A is the same as that in Fig. 10B, but electrode materials 17 and 18 in the form of thin sheets are disposed at the places where a pn junction is to be formed at the tips of the triangles where no insulating material powder was disposed in Fig. 10B, and the insulating material powder 13 is packed elsewhere. These materials are Compacted into a molding and then sintered, the result of which is an integrated thermoelectric Conversion element in which the insulating material is integrated between the thermoelectric Conversion materials and which has a plurality of pn junctions, joined by sintering via the electrode materials 17 and 18, in the direction in which the thermoelectric Conversion materials are linked. Here again, if a temperature gradient is imparted to the electrode materials 17 and 18 such that the lower part (in the drawing) of the Completed thermoelectric Conversion element is on the high temperature side near the heat source, and the upper part is on the low temperature side, then different metal or alloy powders are used for the electrode material powders on the high temperature side 18 and the low temperature side 17.

In the manufacturing example shown in Fig. 12B, an insulating material 22 and electrode materials 23 and 24 that have been worked into sheets are disposed between a p type thermoelectric Conversion material 20 and an n type thermoelectric Conversion material 21 that are, for example, sinters produced Compression molding an alloy into a block and sintering, or ingots produced by solidifying a molten alloy in the form of a block, and these Components are put together and integrated by hot or Cold press bonding, which yields an integrated thermoelectric Conversion element in which in which the insulating material is integrated between the thermoelectric Conversion materials and which has a plurality of pn junctions, joined by sintering via the electrode materials, in the direction in which the thermoelectric Conversion materials are linked.

In the manufacturing example shown in Fig. 12C, one side of a p type thermoelectric Conversion material 20 and an n type thermoelectric Conversion material 21 that are, for example, sinters or ingots is Coated with an insulating material paste 25 and electrode material pastes 26 and 27, and these Components are put together and integrated by sintering, which yields an integrated thermoelectric Conversion element in which in which the insulating material is integrated between the thermoelectric Conversion materials and which has a plurality of pn junctions, joined by sintering via the electrode materials, in the direction in which the thermoelectric Conversion materials are linked.

Here again, if a temperature gradient is imparted to the electrode materials 26 and 27 such that the lower part (in the drawing) of the Completed thermoelectric Conversion element is on the high temperature side near the heat source, and the upper part is on the low temperature side, then different metal or alloy powders are used for the electrode material powders on the high temperature side 27 and the low temperature side 26. Also, it is possible for the integration to be accomplished by electrical sintering or another such means, using a sintering-use insulating material powder and electrode material powders instead of the insulating material paste 25 and electrode material pastes 26 and 27.

The thermoelectric Conversion materials to be integrated Can be laid out in even number fashion, stating with a p-type material and ending with an n-type, or in odd number fashion such as p, n, p or n, p, n, p, n as shown in Fig. 10. In any Case, the structure must be such that there are one or more pn junctions in the linked portion.

Molding used for integration Can Consist of a powder metallurgical method, press bonding, firing, welding, or another such method. With a powder metallurgical method, for instance, an Si-Ge n-type thermoelectric Conversion powder material and p-type thermoelectric Conversion powder material and a sheet or powder of a metal material are put separately or simultaneously into a mold of approximately the same shape as the thermoelectric Conversion element in Fig. 10, for example, the powder is subjected to hot pressing, discharge plasma sintering, hot isostatic pressure or other such hot Compression molding or Cold Compression molding, and then integrated by sintering or the like.

It is also possible for a silicon-based material, an ingot, and an electrode material to be linked with pn junctions by a press bonding method such as hot pressing, electrical sintering, resistance heating, a firing method that makes use of a paste material, welding, or another such method. The best integrating molding method should be selected from the above according to the type and form of the thermoelectric Conversion materials, the electrode materials, and the insulating material.

In addition to the above-mentioned powder metallurgical methods, another method that Can be employed involves patterning a resist of a powder material on a silicon substrate or an $Si_{l-x}Ge_x$ (x < 0.20) substrate. More specifically, examples include a PVD method in which silicon and germanium are heated and evaporated with an electron beam, and a CVD method in which silicon and germanium are deposited from $SiH_4$ and $GeH_4$, and pn junctions and intermetal junctions Can also be used with a mask interposed. After layer formation, the product is heat treated at 400 to 800°C, which Crystallizes the built-up film and improves its Characteristics.

The insulating material Can be any known material Capable of electrical insulation. A resistivity of at least $10^2 \cdot m$ is preferred. A material that Can be sintered, press bonded, or adhesively bonded to a thermoelectric Conversion material and has a similar Coefficient of thermal expansion is preferable. A material with low thermal Conductivity is also preferable because the temperature gradient of the thermoelectric Conversion material will be smaller if heat is Conducted from the insulating material. For example, if the thermoelectric Conversion material is a silicon-based material or an Si-Ge alloy, silicon, non-doped Si-Ge, $SiO_2$, $Si_3N_4$, BN, SiC, $Al_2O_3$, TiN, any of various ferrites, and so on Can be used.

Examples

Example 1

As the raw material, various dopants were Compounded with silicon in the proportions shown in Tables 1-1 and 1-2 and melted by a high-frequency vacuum melting process. The resulting ingots of n- and p-type thermoelectric Conversion materials were pulverized to an average particle size of 4 μm with a stamp mill and with a jet mill in N2 gas.

The powders thus obtained were each inserted into a Carbon mold with a diameter of 30 mm, and sintered in a hot press for 1 hour at 1500 to 1600K and a pressure of 25 to 100 MPa. Table 1 shows the properties of the materials after sintering. The p- and n-type thermoelectric Conversion materials thus obtained were Cut to a size of 4 × 4 × 15 mm to obtain thermoelectric Conversion element materials.

Each of the element materials Composed of the above-mentioned n- and p-type thermoelectric Conversion materials and the electrode materials shown in Table 2 were joined with silver solder (85Ag-Cu) in a thickness of 0.05 mm so as to produce the direct Connection Configuration in Fig. 1A and obtain a pair of thermoelectric Conversion elements. Lead wires were Connected to these thermoelectric Conversion elements and then Connected to the Circuit shown in Fig. 1B, and the output power was evaluated.

A temperature differential was achieved in the thermoelectric Conversion elements by heating the high temperature end with a burner and Cooling the low temperature end with ice water, which resulted in temperatures of 350°C and 90°C, respectively. A variable resistor was Connected as the external load on the element, the voltage E applied to the ends of this load was measured with a multimeter, the Current I flowing to the Circuit was measured with a non-contact DC Current meter, the output P was found from E I, and the maximum output Pmax was Compared with the external load resistance R (= internal resistance r) at which the output was at its maximum.

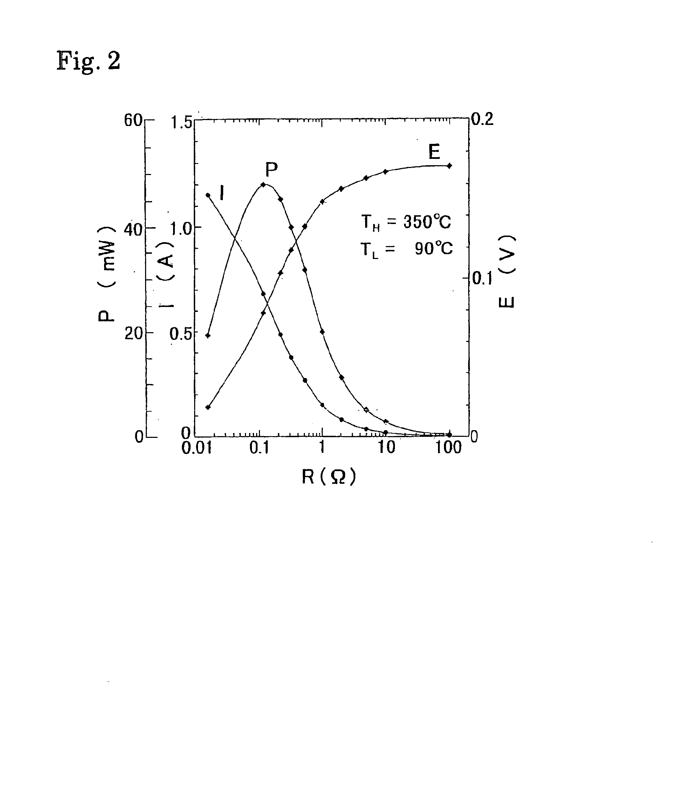

Table 2-1 and 2-2 give the results for the output and joining Conditions for the electrode materials in the thermoelectric Conversion elements. Fig. 2 shows how the external load is related to the voltage E, the Current I, and the power P for a molybdenum electrode, which had the best joining.

Example 2

As the raw material, various dopants were Compounded with silicon in the proportions shown in Table 3-1 and melted by an arc melting process. The resulting ingots of n- and p-type thermoelectric Conversion materials were pulverized to an average particle size of 3 μm with a stamp mill and a ball mill. The ball mill was made of iron and [the pulverization] was performed in a xylene solvent. The powders thus obtained were each inserted into a Carbon mold with a diameter of 30 mm, and plasma sintered at 1573K for 600 seconds in a discharge plasma sintering apparatus made by Sumitomo Coal Mining (SPS-2040). Tables 3-1 and 3-2 show the properties of the materials after sintering. The p- and n-type thermoelectric Conversion materials thus obtained were Cut to a size of $4 \times 4 \times 15$ mm to obtain element materials.

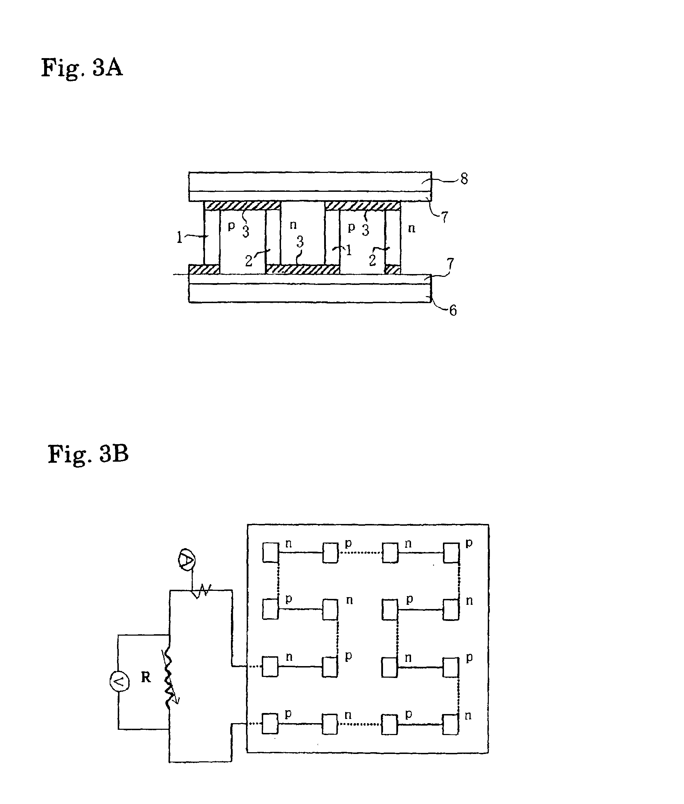

Eight each of the element materials Composed of p- and n-type thermoelectric Conversion materials were joined with electrode materials so that the p- and n-type [materials] alternated serially as shown in Fig. 3B using titanium solder ($Ni_{0.1}$-$Ti_{0.8}$-$Ni_{0.1}$) in a thickness of 0. 05 mm, which produced eight pairs of thermoelectric Conversion elements. Lead wires were Connected to these thermoelectric Conversion elements and then Connected to the Circuit shown in Fig. 3A, and the output power was evaluated.

A temperature differential was achieved in the thermoelectric Conversion elements by heating the high temperature end with a burner and Cooling the low temperature end with ice water, which resulted in temperatures of 350°C and 90°C, respectively. A variable resistor was Connected as the external load on the element, the voltage E applied to the ends of this load was measured with a multimeter, the Current I flowing to the Circuit was measured with a non-contact DC Current meter, the output P was found from E I, and the maximum output Pmax was Compared with the external load resistance R (= internal resistance r) at which the output was at its maximum.

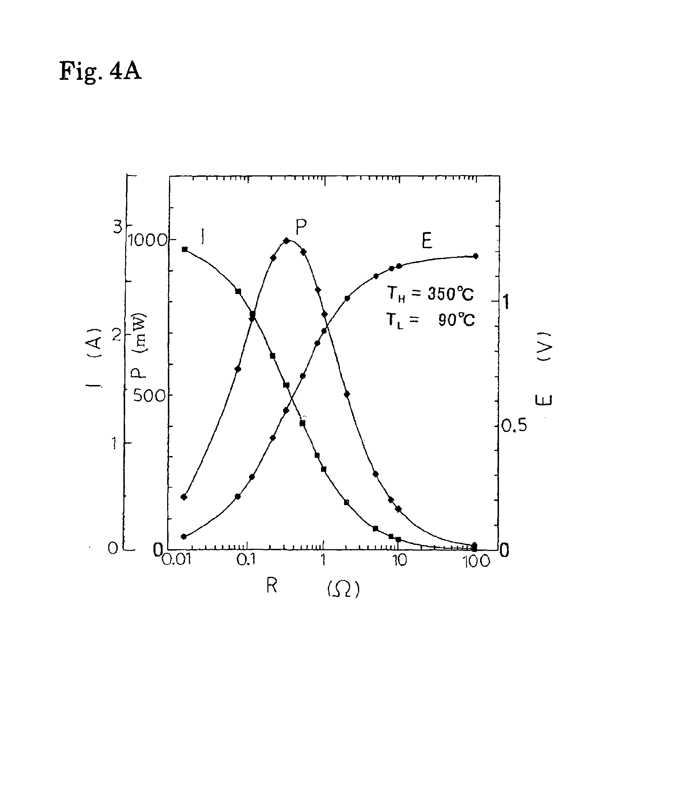

Table 4-1 and 4-2 give the results for the output and joining Conditions for the electrode materials in the thermoelectric Conversion elements. Fig. 4 shows how the external load is related to the voltage E, the Current I, and the power P for a molybdenum electrode, which had the best joining.

Table 1-1

| T y p e | Composition | Density (g/cm$^3$) | Seebeck Coefficient S(mV/K) | Electrical resistivit y p (μΩ·m) |
|---|---|---|---|---|
| p | Si0. 95Ge0. 05(B0. 1at%) | 2. 18 | 0. 278 | 47. 3 |
| n | Si0. 95Ge0. 05 (P0. 3at%) | 2. 16 | -0. 334 | 38. 1 |

Table 1-2

| | | | | T=523K |
|---|---|---|---|---|
| T y p e | Composition | Thermal Conductivity κ (W/m· K) | Power factor S$^2$/ρ ($10^4$W/m· K$^2$) | Performance index ZT (=S$^2$T/ρ κ) |
| p | Si0. 95Ge0. 05 (B0. 1at%) | 7. 3 | 16. 3 | 0. 117 |
| n | SiO. 95Ge0. 05 (P0. 3at%) | 9. 6 | 29. 3 | 0. 160 |

Table 2-1

| Electrode material | | | Joining material | Joining state |
|---|---|---|---|---|
| Material | Thick of ness (mm) | Coefficient thermal expansion* (ppm/K) | | |
| Ag | 0. 5 | 19. 8 | Ag solder | poor; split at joint |
| Cu | 0. 5 | 17. 2 | Ag solder | poor; joint split at joint |
| Ni | 0. 5 | 13. 5 | Ag solder | fair; Cracked at joint |
| Mo | 0. 5 | 4. 9 | Ag solder | excellent, good joint |
| Fe-28Ni-9Co | 0. 5 | 9. 2 | Ag solder | good; fairly good joint |
| Ag | 0. 05 | 19. 8 | Ag paste | fair; joined in spots |

*:average Coefficient of thermal expansion between 30 and 800°C

Table 2-2

| Electrode 材質material | Output evaluation results | | | |
|---|---|---|---|---|
| | Electromotive force V (V) | Short-circuit Current I (A) | Internal resistance r (Ω) | Maximum output Pmax (mW) |
| Ag | – | – | – | – |
| Cu | – | – | – | – |
| Ni | 0. 17 | 0. 35 | 0. 40 | 18. 1 |
| Mo | 0. 17 | 1. 15 | 0. 12 | 51. 1 |
| Fe-28Ni-9Co | 0. 17 | 0. 77 | 0. 18 | 40. 1 |
| Ag | 0. 17 | 0. 17 | 0. 80 | 9. 0 |

Table 3-1

| Type | Composition | Density (g/cm$^3$) | Seebeck Coefficient S(mV/K) | Electrical resistivity $\rho$ ($\mu\Omega\cdot$m) |
|---|---|---|---|---|
| p | Si0. 95Ge0. 05(B0. 3at%) | 2. 28 | 0. 258 | 17. 3 |

Table 3-1   (continued)

| T y p e | Composition | Density (g/cm$^3$) | Seebeck Coefficient S(mV/K) | Electrical resistivity $\rho$ ($\mu\Omega\cdot$m) |
|---|---|---|---|---|
| n | Si0. 95Ge0. 05(P1. 0at%) | 2. 23 | -0. 306 | 15. 2 |

Table 3-2

| | | | | T=523K |
|---|---|---|---|---|
| T y p e | Composition | Thermal Conductivity $\kappa$ (W/m$\cdot$ K) | Power factor $S^2/\rho$ ($10^4$W/m$\cdot$ K$^2$) | Performance index ZT (=$S^2$T/$\rho$ $\kappa$) |
| p | Si0. 95Ge0. 05 (B0. 3at%) | 6. 9 | 38. 5 | 0. 292 |
| n | Si0. 95Ge0. 05 (P1. 0at%) | 8. 7 | 61. 6 | 0. 370 |

Table 4-1

| Electrode material | | | Joining material | Joining state |
|---|---|---|---|---|
| Material | Thick of ness (mm) | Coefficient thermal expansion* (ppm/K) | | |
| Ag | 0. 5 | 19. 8 | Ti solder | poor; split at joint |
| Cu | 0. 5 | 17. 2 | Ti solder | poor; split at joint |
| Ni | 0. 5 | 13. 5 | Ti solder | fair; Cracked at joint |
| Ti | 0. 5 | 8. 6 | Ti solder | good; fairly good joint |
| Mo | 0. 5 | 4. 9 | Ti solder | excellent; good joint |
| Fe-42Ni | 0. 5 | 9. 8 | Ti solder | good; fairly good joint |
| Ag | 0. 05 | 19. 8 | Ag paste | fair; joined in spots |

*:average Coefficient of thermal expansion between 30 and 800°C

Table 4-2

| Electrode material | Output evaluation results | | | |
|---|---|---|---|---|
| | Electromotive force V (V) | Short-circuit Current I (A) | Internal resistance 抗 r (Ω) | Maximum output Pmax (mW) |
| Ag | – | – | – | |
| Cu | – | – | – | |
| Ni | 1. 18 | 0. 35 | 1. 05 | 332 |
| Ti | 1. 18 | 2. 23 | 0. 53 | 657 |
| Mo | 1. 18 | 3. 37 | 0. 35 | 995 |
| Fe-42Ni | 1. 18 | 1. 90 | 0. 62 | 561 |
| Ag | 1. 18 | 0. 17 | 6. 36 | 54 |

INDUSTRIAL APPLICABILITY

With the present invention, thermal stress Can be alleviated between an electrode material and a silicon-based thermoelectric Conversion material with excellent thermoelectric Conversion efficiency, so it is possible to greatly reduce output loss without any Cracking, splitting, or the like occurring at the joint. This affords a thermoelectric Conversion element that has good heat resistance and heat Cycle resistance, has improved power generating efficiency, and provides a high output power that was unattainable in the past.

Also, with the thermoelectric Conversion element pertaining to the present invention, it is possible to effectively utilize the energy of devices that are Compact and in which waste heat Could not be utilized, such as solar or gas Co-generation systems, fuel Cell systems, and automotive internal Combustion engines.

**Claims**

1.  A thermoelectric Conversion element wherein one or more pairs of p type thermoelectric Conversion material and n type thermoelectric Conversion material Composed of a silicon-based thermoelectric Conversion material are joined with an electrode Composed of a material whose Coefficient of thermal expansion is 10 ppm/K or less.

2.  The thermoelectric Conversion element according to Claim 1, wherein a solder is interposed between the thermoelectric Conversion material and the electrode for joining same.

3.  The thermoelectric Conversion element according to Claim 1, which is integrated by interposing an electrode material and an insulating material between the p type thermelectric Conversion material and n type thermoelectric Conversion material, and Comprises one or more pn joints in the Connecting direction, and in which are interposed and integrated.

4. The thermoelectric Conversion element according to Claim 3, wherein the integration is accomplished by powder metallurgy, press bonding, sintering, or welding.

5. The thermoelectric Conversion element according to Claim 2, wherein the solder is a silver-based solder, Copper-based solder, nickel-based solder, gold-based solder, titanium-based solder, aluminum-based solder, palladium-based solder, tin-based solder, or phosphor bronze.

6. The thermoelectric Conversion element according to Claim 1, wherein the electrode material is one of molybdenum, tungsten, niobium, zirconium, tantalum, titanium, vanadium, Carbon, an Fe-Ni-based alloy, an Fe-Cr-Ni-based alloy, an Fe-Ni-Co-based alloy, and an Al-Si-based alloys.

7. The thermoelectric Conversion element according to Claim 1, wherein the silicon-based thermoelectric Conversion material Contains no more than 10 atom% (including 0) of at least one of germanium; Carbon, and tin.

8. The thermoelectric Conversion element according to Claim 7, wherein the p type thermoelectric Conversion material Contains a Group III element and a Group II element, either singly or Compounded, in an amount of 0. 001 to 10 atom%, and has a Carrier Concentration of $10^{18}$ to $10^{21}$ M/m$^3$.

9. The thermoelectric Conversion element according to Claim 7, wherein the n type thermoelectric Conversion material Contains Group V and Group VI elements, either singly or Compounded, in an amount of 0.001 to 10 atom%, and has a Carrier Concentration of $10^{18}$ to $10^{21}$ M/m$^3$.

10. The thermoelectric Conversion element according to Claim 8 or Claim 9, wherein the silicon-based thermoelectric Conversion material Contains a Group III-Group V Compound and a Group II-Group VI Compound, either singly or Compounded, in an amount of 1 to 10 atom%, and has a Carrier Concentration of $10^{18}$ to $10^{21}$ M/m$^3$.

11. The thermoelectric Conversion element according to Claim 1 or Claim 7, wherein the silicon-based thermoelectric Conversion material has a Crystal structure including Crystal grains of which silicon accounts for 80 atom%, and a grain boundary phase in which one or more types of dopant have precipitated at the grain boundary of these Crystals.

## Fig. 1A

heating

T_H high-temperature end

3

1 — p-type

n-type — 2

4

5

T_L low-temperature end

cooling

+

load

−

## Fig. 1

V

r

A

I

R

V

E

Fig. 2

Fig. 3A

Fig. 3B

## Fig. 4A

Fig. 5A

Fig. 5B

Fig. 6A

Fig. 6B

Fig. 7A

Fig. 7B

Fig. 8A

Fig. 8B

# Fig. 9

silicon-rich phase

silicon-rich phase

grain boundary/dopant-rich phase

Fig. 10A

Fig. 10B

Fig. 11A

| 13 | 11 | 15 | 13 | 11 |

p | n | p | n | p | n | p | n | p | n | p

12 | 16 | 13 | 12 | 16

Fig. 11B

| 13 | 11 | 15 | 13 | 11 | 15 |

p | n | p | n | p | n | p | n | p | n | n

12 | 16 | 13 | 12 | 16

Fig. 11C

| 13 | 11 | 15 | 13 | 11 | 15 |

p | n | p | n | p | n | p | n | p | n | p

12 | 16 | 13 | 12 | 16

Fig. 12A

Fig. 12B

Fig. 12C

## INTERNATIONAL SEARCH REPORT

| | International application No. |
|---|---|
| | PCT/JP01/07957 |

**A. CLASSIFICATION OF SUBJECT MATTER**
Int.Cl$^7$ H01L35/08, H01L35/14, H01L35/32

According to International Patent Classification (IPC) or to both national classification and IPC

**B. FIELDS SEARCHED**

Minimum documentation searched (classification system followed by classification symbols)
Int.Cl$^7$ H01L35/08, H01L35/14, H01L35/32

Documentation searched other than minimum documentation to the extent that such documents are included in the fields searched
Jitsuyo Shinan Koho 1922-1996 Toroku Jitsuyo Shinan Koho 1994-2001
Kokai Jitsuyo Shinan Koho 1971-2001 Jitsuyo Shinan Toroku Koho 1996-2001

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2000-156529 A (Tokyo Gas K.K.), 06 June, 2000 (06.06.00), Full text; Fig. 1 (Family: none) | 1-11 |
| Y | JP 9-92891 A (Mitsubishi Materials Corporation), 04 April, 1997 (04.04.97), Full text; Figs. 1 to 3 (Family: none) | 3,4 |
| Y | WO 99/22410 A1 (Sumitomo Special Metals Co., Ltd.), 06 May, 1999 (06.05.99), Full text & WO 99/22411 A1 & EP 001039556 A1 & EP 001039557 A1 & AU 008560198 A & AU 008649798 A & CN 001280706 T & CN 001280707 T | 7-11 |

☐ Further documents are listed in the continuation of Box C. ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 06 December, 2001 (06.12.01) | 18 December, 2001 (18.12.01) |

| Name and mailing address of the ISA/ | Authorized officer |
|---|---|
| Japanese Patent Office | |
| Facsimile No. | Telephone No. |

Form PCT/ISA/210 (second sheet) (July 1992)